Europäisches Patentamt

European Patent Office

Office européen des brevets

(11) Veröffentlichungsnummer: **0 048 324**
**A1**

(12) **EUROPÄISCHE PATENTANMELDUNG**

(21) Anmeldenummer: **81105905.4**

(22) Anmeldetag: **27.07.81**

(51) Int. Cl.³: **G 01 R 31/26**

(30) Priorität: **24.09.80 CH 7139/80**

(43) Veröffentlichungstag der Anmeldung:
**31.03.82 Patentblatt 82/13**

(84) Benannte Vertragsstaaten:
**AT BE DE FR GB IT LU NL SE**

(71) Anmelder: **Walter Hanselmann AG Fesy Elektronik**
**Kanalstrasse 17**
**CH-8152 Glattbrugg(CH)**

(72) Erfinder: **Zindel, Ernst K.**
**Bläsistrasse 31**
**CH-8049 Zürich(CH)**

(74) Vertreter: **Blum, Rudolf E. et al,**
**c/o E. Blum & Co Patentanwälte Vorderberg 11**
**CH-8044 Zürich(CH)**

(54) Gerät zum Prüfen aktiver Halbleiterbauelemente.

(57) Das Prüfgerät enthält für jeden Prüflingstyp wenigstens eine Prüfschaltungsanordnung. Den verschiedenen Prüfschaltungsanordnungen (1 bis 6) ist ein gemeinsamer Schaltungsteil zugeordnet, der eine Spannungsquelle (7), ein Anzeigeinstrument (8) und eine Einrichtung (9) zum Anschluss der Prüflinge umfasst. Die Prüfschaltungsanordnungen werden mit Hilfe eines Wählschalters (10) einzeln aufgebaut und sind so dimensioniert, dass in jeder Stellung des Wählschalters und bei richtigem oder falschem Anschluss eines Prüflings kein das Gerät oder den Prüfling gefährdender Strom fliessen kann. Jeder falsche Anschluss wird am Anzeigeinstrument (8) angezeigt. Mit diesem Prüfgerät können Dioden und Transistoren und noch eine Vielzahl anderer gängiger Typen von Halbleiterbauelementen auf ihre Funktion geprüft werden. Ausserdem ermöglicht es eine Identifizierung unbekannter Typen von Halbleiterbauelementen und deren Anschlüsse.

## Gerät zum Prüfen aktiver Halbleiterbauelemente

Es gibt Geräte zum Prüfen aktiver Halbleiterbauelemente, welche eine einfache Funktionsprüfung bestimmter Halbleiterbauelemente und einen Qualitätsvergleich unter gleichartigen Halbleiterbauelementen ermöglichen. Mit handelsüblichen Geräten dieser Art lassen sich im wesentlichen Dioden und Transistoren prüfen, wobei die Prüfung in der Regel auf einer einfachen Widerstandsmessung beruht.

Die Prüfung anderer Typen von Halbleiterbauelementen, wie z.B. Thyristoren, Diac's, Triac's, Zenerdioden, Feldeffekttransistoren usw., erfordert normalerweise eine für jeden Prüflingstyp eigens aufgebaute Prüfschaltung, was sich in der Praxis wegen der damit verbundenen Umtriebe, insbesondere für Einzelprüfungen, meist nicht lohnt.

Das Ziel der Erfindung ist ein Prüfgerät, das vielseitiger verwendbar ist, mit dem also ausser Dioden und Transistoren auch noch eine Vielzahl anderer gängiger Typen von Halbleiterbauelementen geprüft werden können, und das eine Identifizierung unbekannter Typen von Halbleiterbauelementen und der Anschlüsse von solchen ermöglicht.

Zur Lösung dieser Aufgabe wird ein Gerät zur Prüfung aktiver Halbleiterbauelemente vorgeschlagen, das durch die Merkmale des ersten Patentanspruchs gekennzeichnet ist.

Für die Identifizierung des Prüflingstyps und dessen Anschlüsse macht man sich einerseits die gegebenenfalls vorhandene Ventilwirkung des Prüflings und bei gesteuerten Halbleiterbauelementen zudem die Anzeige der jeweiligen Steuerwirkung zunutze.

In der Zeichnung ist ein Ausführungsbeispiel der Erfindung

XX                                        EU 1072

schematisch dargestellt, und zwar zeigen:

Fig. 1 das Blockschema des Gerätes;

Fig. 2 eine Prüfschaltungsanordnung zum Prüfen von ohm'-schen Widerständen, Diac's, Photodioden, Photowiderständen, Opto-Kopplern, Heiss- und Kaltleitern sowie für Leitungs- und Kurzschlussprüfungen;

Fig. 3 eine Prüfschaltungsanordnung für Zenerdioden;

Fig. 4 eine Prüfschaltungsanordnung für Thyristoren und Triac's;

Fig. 5 eine Prüfschaltungsanordnung für NPN-Transistoren;

Fig. 6 eine Prüfschaltungsanordnung für N-Kanal-Feldeffekttransistoren und

Fig. 7 eine Prüfschaltungsanordnung für Dioden und Diodenstrecken anderer Prüflingstypen.

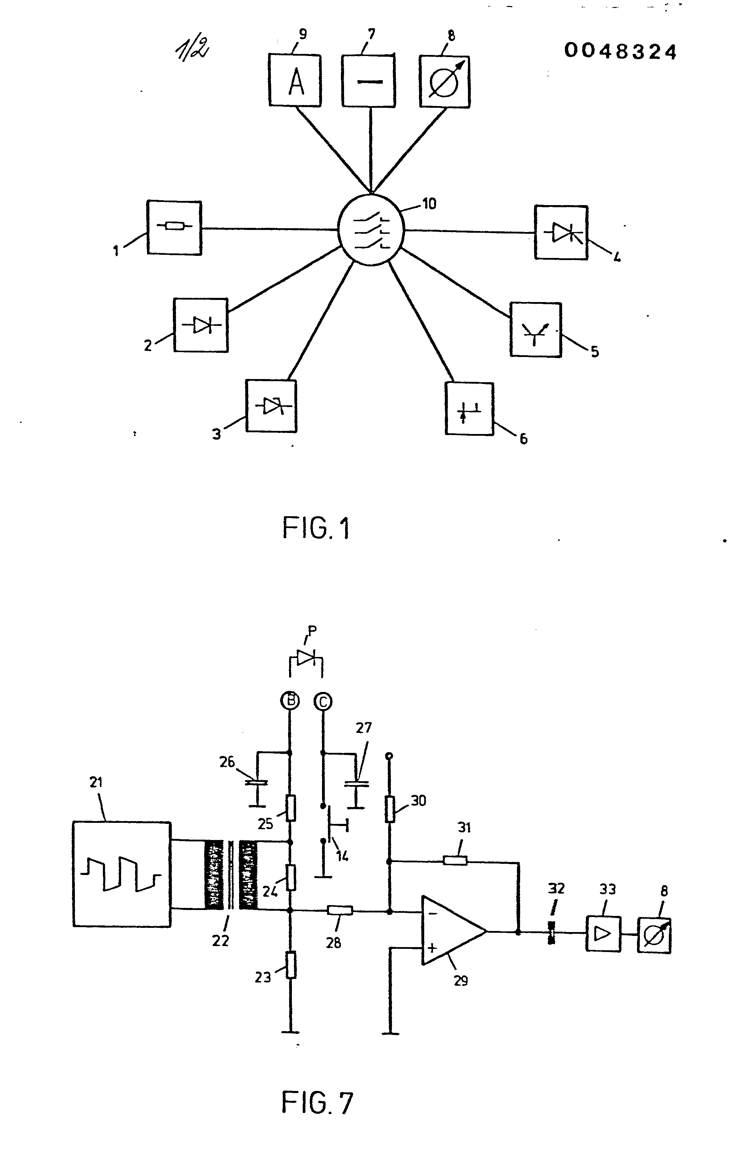

Im Blockschema nach Fig. 1 ist mit den Blöcken 1 bis 6 und den Symbolen darin angedeutet, dass für jeden Prüflingstyp eine Prüfschaltungsanordnung mit festen Kennwerten vorgesehen ist. Den Prüfschaltungsanordnungen ist ein gemeinsamer Schaltungsteil zugeordnet, der eine Spannungsquelle 7, ein Anzeigeinstrument 8 und eine Einrichtung 9 zum Anschluss der Prüflinge enthält. Die Prüfschaltungsanordnungen 1 bis 6 werden mit Hilfe eines Wählschalters 10 mit mehreren Schaltebenen wechselweise einzeln aufgebaut.

Die Spannungsquelle 7 umfasst vorzugsweise einen Netzgleichrichter mit einem Spannungsteiler, an dem Gleichspannungen verschiedener Werte abgenommen werden können, sowie einen Oszillator zur Erzeugung eines Wechselsignals, das insbesondere für die Diodenprüfung benötigt wird.

Als Anzeigeinstrument 8 dient normalerweise ein Drehspulinstrument. Die Anzeige kann jedoch auch mit anderen Mitteln oder auf andere Weise, z.B. digital, erfolgen. Da das Anzeigeinstrument in verschiedenen Stromkreisen mit unterschiedlichen Stromstärkeverhältnissen benützt wird, sind wahlweise zuschaltbare Nebenschlüsse vorgesehen. Ausserdem ist dem Anzeigeinstrument ein Eichregler zugeordnet, um den Zeiger jeweils auf den Eichpunkt einzustellen, der sich normalerweise am oberen Skalenende, bei der Diodenprüfung jedoch in der Skalenmitte befindet.

Die Einrichtung 9 zum Anschluss der Prüflinge besteht im einfachsten Fall aus drei Steckbuchsen für Prüfkabel. Zusätzlich oder stattdessen können Stecksockel vorgesehen sein, wie sie für die verschiedenen Prüflingstypen betriebsmassig üblich sind. Im vorliegenden Beispiel sind drei Anschlussklemmen A, B und C vorgesehen, denen am Gerät die jeweils gebräuchlichen Bezeichnungen der Anschlüsse der Prüflingstypen zugeordnet sind, z.B. B, C und E als Bezeichnung für Basis, Kollektor und Emitter bei Transistoren oder G, A und K als Bezeichnung für Gate, Anode und Kathode bei Thyristoren. Diese Bezeichnungen am Gerät ermöglichen das Identifizieren der Anschlüsse des an die Anschlussklemmen angeschlossenen Prüflings, wenn die Prüfung mit dem Anzeigeinstrument ergeben hat, dass der Prüfling richtig angeschlossen ist.

In den Figuren der nachfolgend beschriebenen Prüfschaltungsanordnungen sind die Schaltkontakte des Wählschalters, welche die einzelnen Schaltungselemente miteinander verbinden, der Einfachheit halber weggelassen worden. Beim Aufbau einer Prüfschaltungsanordnung wird praktisch jedes Schaltungselement einzeln über den Wählschalter in den Stromkreis eingefügt.

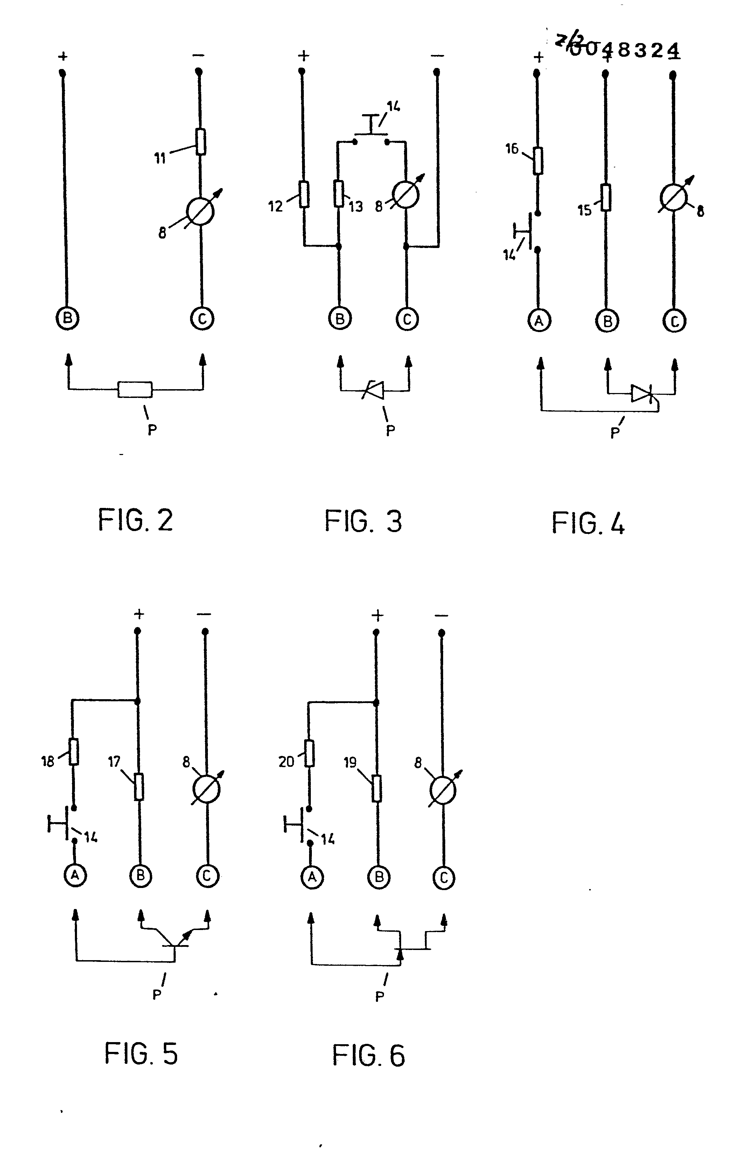

Die Prüfschaltungsanordnung nach Fig. 2 umfasst einen Stromkreis, bei dem der Pluspol der Gleichspannungsquelle mit der Anschlussklemme B und der Minuspol der Gleichspannungs-

quelle über einen ohmschen Widerstand 11 und das Drehspulinstrument 8 mit der Anschlussklemme C verbunden sind. Mit dieser Prüfschaltungsanordnung können Widerstandsmessungen vorgenommen werden, wozu das Drehspulinstrument 8 eine in Widerstandswerten geeichte Skala trägt. Ausserdem lassen sich damit Heissleiter, Kaltleiter, Photowiderstände, Optowiderstände, Opto-Koppler auf ihre Funktion prüfen, Diac's auf Kurzschluss prüfen und Polaritätsanschlüsse von Elektrolytkondensatoren, Tantalkondensatoren, Photo-Dioden usw. identifizieren. Durchgang, Unterbruch oder Kurzschluss sind beim angeschlossenen Prüfling P generell feststellbar. Die Spannung der Gleichspannungsquelle beträgt bei dieser Prüfschaltungsanordnung beispielsweise 16 V.

Zum Prüfen von Zenerdioden bedient man sich der Prüfschaltungsanordnung nach Fig. 3. Der Pluspol der Gleichspannungsquelle mit einer Spannung von z.B. 65 V ist über einen ohmschen Widerstand 12 mit der Anschlussklemme B, der Minuspol mit der Anschlussklemme C verbunden. Diese Anschlussklemmen werden ferner überbrückt durch einen Seriestromkreis, der durch einen Vorwiderstand 13, eine Prüftaste 14 mit einem Arbeitskontakt und das Drehspulinstrument 8 gebildet wird. Der Prüfling P wird mit seiner Anode an die Anschlussklemme C und mit seiner Kathode an die Anschlussklemme B angeschlossen. Das Drehspulinstrument trägt eine Spannungsskala, an der die Zenerspannung bei Betätigung der Prüftaste 14 direkt ablesbar ist. In gleicher Weise kann die Durchbruchspannung von Diac's gemessen werden.

Die Prüfschaltungsanordnung nach Fig. 4 für Thyristoren weist einen Arbeits- und einen Steuerstromzweig auf. Der Arbeitstromzweig liegt an einer Gleichspannung von z.B. 45 V, wobei der Pluspol über einen ohmschen Widerstand 15 an die Anschlussklemme B und der Minuspol über das Drehspulinstrument 8 an die Anschlussklemme C führt. Der an die Anschlussklemme A führende Steuerstromzweig enthält in Serie einen ohmschen Widerstand 16 und die Prüftaste 14 und liegt an einer Gleichspannung von z.B. + 16 V. Der Prüfling P wird mit der Steuerelektrode (Gate) an die Anschlussklemme A, mit der Anode an die Anschlussklemme B und mit der Kathode an die Anschlussklemme C angeschlossen. Der Prüfling kann auf Kurzschluss oder Unterbruch untersucht werden. Ausserdem kann sein Haltestrom gemessen werden.

Die Prüfschaltungsanordnung für NPN-Transistoren nach Fig. 5 ist ähnlich aufgebaut wie diejenige nach Fig. 4. Zum Unterschied dazu liegen hier der Arbeits- und der Steuerstrom an gleiche ' Spannung von beispielsweise 4 V. Zudem enthalten sie andere Widerstände 17 bzw. 18. Basis, Kollektor und Emitter des Transistors sind in dieser Reihenfolge an die Anschlussklemmen A, B bzw. C anzuschliessen. Die Prüfschaltungsanordnung für PNP-Transistoren unterscheidet sich von derjenigen nach Fig. 5 im Aufbau lediglich dadurch, dass das Drehspulinstrument 8 und der Widerstand 17 ihre Plätze tauschen und die Spannungsquelle umgepolt wird, während der Prüfling in gleicher Weise angeschlossen wird. Neben einer Funktionsprüfung kann auch eine vergleichsweise Verstärkungsmessung an mehreren Prüflingen vom gleichen Typ vorgenommen werden.

Eine ähnliche Prüfschaltungsanordnung kann für die Funktionsprüfung von Feldeffekttransistoren vorgesehen sein. Fig. 6 zeigt die Prüfschaltungsanordnung für N-Kanal-Feldeffekttransistoren, die sich gegenüber Fig. 5 nur durch eine andere Speisespannung von z.B. 16 V und Widerstände 19 und 20 mit anderen Werten unterscheidet. Für P-Kanal-Feldeffekttransistoren wird der Schaltungsaufbau in gleicher Weise geändert wie bei der Prüfschaltungsanordnung nach Fig. 5 für PNP-Transistoren.

Unter Umständen kann es zweckmässig sein, die Prüfschaltungsanordnungen nach den Fig. 2 bis 6 oder einzelne davon z.B. diejenige für Transistoren, mehrfach, z.B. doppelt vorzusehen und für verschiedene Leistungsgrössenbereiche der Prüflinge zu dimensionieren.

Eine Besonderheit stellt die Prüfschaltungsanordnung nach Fig. 7 zum Prüfen von Dioden dar. Sie stellt eine Weiterentwicklung des in der CH-PS 607 045 beschriebenen Diodenprüfgerätes dar. Das diesem Gerät zugrunde liegende Prüfverfahren besteht darin, dass der zu prüfenden Diode ein Wechselsignal zugeführt wird, dass ein Pegelbereich des diodenverzerrten Wechselsignals selektioniert wird, wobei man als Pegelbereich einen das Schaltverhalten der Diode charakterisierenden Wechselsignalbereich selektioniert, und dass der selektionierte Signal-Pegelbereich zur Fehlerdetektierung ausgewertet wird.

Zur Ausführung dieses Verfahrens sind bei der Prüfschaltungsanordnung nach Fig. 7 im Prinzip die gleichen Mittel verwendet, wie sie beim Diodenprüfgerät nach der CH-PS 607 045 vorgesehen sind. Ein aus der gemeinsamen Spannungsquelle 7 (Fig. 1) gespeister Oszillator 21 erzeugt das Wechselsignal, das im vorliegenden Beispiel ein Rechtecksignal mit abfallendem Impulsdach ist und eine Frequenz im Bereich von 800 bis 1000 Hz hat. Experimente haben gezeigt, dass sich mit einem Wechselsignal dieser Form und Frequenz bei unterschiedlichen Diodentypen, die abwechselnd in Durchlass- und Sperrichtung angeschlossen werden, im Durchschnitt grössere Auswertesignale erreichen lassen als mit jedem andersartigen Wechselsignal. Ueber einen Transformator 22 gelangt das Wechselsignal in den Prüfstromkreis, der aus der Reihenschaltung aus einem Widerstand 23, der mit einem Widerstand 24 überbrückten Sekundärwicklung des Transformators 22. einem weiteren Widerstand 25, den Anschlussklemmen B, C für den Prüfling P und dem Tastenschalter 14 besteht. Die Anschlussklemmen B, C sind durch
Kondensatoren 26, 27 gegen Masse abgeblockt. Am Widerstand
23 wird eine dem Strom durch den Prüfling P proportionale
Spannung abgenommen und zur Auswertung über einen Widerstand 28 einem als Umkehrverstärker geschalteten Differenzverstärker zugeführt, der mit einem Operationsverstärker 29
realisiert ist. Der invertierende Eingang des Operationsverstärkers 29 ist über einen Widerstand 30 mit dem positiven Pol der Speisespannungsquelle verbunden, während der
nichtinvertierende Eingang desselben an Masse liegt. Ein
Widerstand 31 verbindet den Ausgang des Operationsverstärkers 29 mit seinem invertierenden Eingang. Der Operationsverstärker 29 ist so eingestellt, dass im wesentlichen nur
die transienten Vorgänge verstärkt werden. Ueber einen
Trennkondensator 32 und einen Verstärker 33 gelangt das
Auswertesignal schliesslich an das Drehspulinstrument 8,
das den Mittelwert des Signalverlaufs anzeigt. Bereits bei
offenen Anschlussklemmen B, C fliesst in einem durch den
Kondensator 26 geschlossenen Stromkreis ein Strom über den
Widerstand 23, der am Drehspulinstrument 8 einen Zeigeranschlag bis zur Skalenmitte bewirkt. Diesem Strom überlagert sich bei angeschlossenem Prüfling P der Diodenstrom,
so dass der Zeiger des Drehspulinstrumentes von diesem
Eichpunkt in der Skalenmitte aus nach rechts ausschlägt,
wenn der Prüfling P in Durchlassrichtung beansprucht wird,
und nach links ausschlägt, wenn der Prüfling P in Sperrrichtung beansprucht wird. Die Umpolung des Prüflings erfolgt mit Hilfe des Wählschalters 10 (Fig. 1). So lässt
sich anhand der Stellung des Wählschalters und der Richtung
des Zeigerausschlages feststellen, ob der Prüfling richtig
angeschlossen ist. Die Grösse des Zeigerausschlages ist ein
Mass für die Güte des Prüflings im jeweiligen Betriebszustand.

- 8 -    0048324

Alle Prüfschaltungsanordnungen sind so dimensioniert, dass nur verhältnismässig kleine Ströme fliessen, damit das Prüfgerät und der Prüfling selbst bei unsachgemässer Behandlung (z.B. Verwechseln der Anschlüsse, Kurzschliessen der Anschlussklemmen, falsche Einstellung des Wählschalters) keinen Schaden nimmt. Dazu sind die jeweiligen Speisespannungen entsprechend niedrig gewählt und in allen Prüfstromkreisen Vorschaltwiderstände vorgesehen.

Im übrigen lassen in allen Prüfschaltungsanordnungen die Anzeigen am Anzeigeinstrument erkennen, wenn der Prüfling falsch angeschlossen ist. Bei richtigem Anschluss des Prüflings erfolgt beispielsweise beim Prüfen steuerbarer Halbleiterbauelemente kein Zeigerausschlag, solange die Prüftaste 14 nicht betätigt wird. Jeder Zeigerausschlag deutet in diesem Fall auf falschen Anschluss hin.

Patentansprüche

1. Gerät zum Prüfen aktiver Halbleiterbauelemente, dadurch gekennzeichnet, dass für jeden Prüflingstyp wenigstens eine Prüfschaltungsanordnung (1 bis 6) mit festen Kennwerten vorgesehen ist, wobei den verschiedenen Prüfschaltungsanordnungen ein gemeinsamer, eine Spannungsquelle (7), ein Anzeigeinstrument (8) und eine Einrichtung (9) zum Anschluss der Prüflinge (P) enthaltender Schaltungsteil zugeordnet ist, und dass die Prüfschaltungsanordnungen mit Hilfe eines Wählschalters (10) wechselweise einzeln aufbaubar und so dimensioniert sind, dass in jeder Stellung des Wählschalters und bei richtigem oder falschem Anschluss eines Prüflings kein das Gerät oder den Prüfling gefährdender Strom fliessen kann und jeder falsche Anschluss am Anzeigeinstrument angezeigt wird.

2. Gerät nach Anspruch 1, dadurch gekennzeichnet, dass die Prüfschaltungsanordnungen zum Prüfen steuerbarer Halbleiterbauelemente einen Arbeits- und einen Steuerstromzweig aufweisen, wobei im Arbeitsstromzweig eine Gleichspannungsquelle, das Anzeigeinstrument (8) und ein ohmscher Widerstand (15, 17, 19) und im Steuerstromzweig die Gleichspannungsquelle, ein Tastenschalter (14) und ein ohmscher Widerstand (16, 18, 20) in Reihe geschaltet sind (Fig. 4 bis 6).

3. Gerät nach Anspruch 2, dadurch gekennzeichnet, dass bei den Prüfschaltungsanordnungen zum Prüfen von Transistoren der Arbeits- und der Steuerstromzweig an gleicher Spannung liegen (Fig. 5,6).

4. Gerät nach Anspruch 1, dadurch gekennzeichnet, dass die Prüfschaltungsanordnung zum Prüfen von Dioden einen Oszillator (21) zur Erzeugung eines Wechselsignals ent-

- 2 -                                    0048324

hält, das über einen Transformator (22) an die Anschlusseinrichtung (B, C) für den Prüfling (P) geführt ist,
dass eine dem Strom durch den Prüfling proportionale
Spannung an einem Seriewiderstand (23) abgenommen und
einem Differenzverstärker (29) zugeführt wird, dessen
Ausgang mit dem Anzeigeinstrument (8) verbunden ist, wobei die Eingangspotentiale des Differenzverstärkers so
eingestellt sind, dass das Drehspulinstrument bei abgeschaltetem Prüfling bis zur Hälfte ausschlägt und bei
angeschaltetem Prüfling von dieser Mittelstellung aus
entsprechend der Polung des Prüflings nach Massgabe der
Sperrwirkung nach links und nach Massgabe der Leitwirkung nach rechts ausschlägt (Fig. 7).

5. Gerät nach Anspruch 4, dadurch gekennzeichnet, dass das
Wechselsignal ein Rechtecksignal mit abfallendem Impulsdach ist und eine Frequenz im Bereich von 800 bis
1000 Hz hat.

6. Gerät nach Anspruch 4, dadurch gekennzeichnet, dass ein
zum Prüfstromkreis paralleler kapazitiver Stromkreis (26)
über den Transformator (22) und den Seriewiderstand (23)
gebildet ist, dessen Strom die Mittelstellung des Anzeigeinstrumentes (8) herbeiführt.

FIG.1

FIG.7

FIG. 2          FIG. 3          FIG. 4

FIG. 5          FIG. 6

0048324

Nummer der Anmeldung

EP 81 10 5905

Europäisches
Patentamt

**EUROPÄISCHER RECHERCHENBERICHT**

| | **EINSCHLÄGIGE DOKUMENTE** | | | KLASSIFIKATION DER ANMELDUNG (Int Cl ³) |
|---|---|---|---|---|
| Kategorie | Kennzeichnung des Dokuments mit Angabe, soweit erforderlich, der maßgeblichen Teile | | betrifft Anspruch | |
| | FUNKSCHAU, Band 44, Heft 12, Juni 1972, Seiten 435-437 München, DE. W. WITTKE: "Minitester für aktive und passive Bauelemente"  * Seiten 435-437, gesamter Artikel * | 1-3 | | G 01 R 31/26 |
| | Q.S.T. AMATEUR RADIO, Band 55, Nr. 9, September 1971, Seiten 19-23 R.M. MASON: "Another transistor tester"  * Seite 19 - Seite 21, linke Spalte, Figur 1 * | 1-3 | | RECHERCHIERTE SACHGEBIETE (Int Cl ³) G 01 R 31/26 |
| | US - A - 3 478 264 (A.N. TSERGAS)  * Spalte 1, Zeilen 12-34; 54-72; Spalte 2 - Spalte 3, Zeile 27; Figuren 1,2 * | 1-3 | | |
| | CH - A - 607 045 (E. HEDINGER)  * Spalte 3, Zeilen 42-56; Ansprüche 1,2; Figur 1 * | 4 | | |
| A | POPULAR MECHANICS, Band 141, Nr. 3, März 1974, Seiten 124-125 L.D. SMITH: "Build this simple transistor tester"  * Abbildung, Seite 125, oben * | 1 | | KATEGORIE DER GENANNTEN DOKUMENTE X: von besonderer Bedeutung A: technologischer Hintergrund O: nichtschriftliche Offenbarung P: Zwischenliteratur T· der Erfindung zugrunde liegende Theorien oder Grundsätze E kollidierende Anmeldung D. in der Anmeldung angeführtes Dokument L. aus andern Gründen angeführtes Dokument &. Mitglied der gleichen Patentfamilie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 10-12-1981 | KUSCHBERT |

EPA form 1503.1   06.78